# EUROPEAN PATENT APPLICATION

(11) **EP 1 198 163 A1**
(43) Date of publication of application: **17.04.2002**
(21) Application number: 99973926.1
(22) Date of filing: 21.06.1999
(51) Int. Cl.: H05K 3/40, H05K 3/34, H01R 12/32

(54) **PROCESS FOR CONNECTING ELECTROCONDUCING TRACKS WHICH ARE SEPARATED BY A LAMINAR INSULATING MATERIAL AND PRINTED CIRCUIT OBTAINED**

(71) Applicant: Mecanismos Auxiliares Industriales S.L., 43800 Valls, Tarragona (ES)
(72) Inventor: CUBERO PINTEL,José Antonio, E-43800 Valls (ES)
(74) Representative: Primo de Rivera y Urquijo, Jose Antonio
(86) International application number: ES9900184
(87) International publication number: WO0079853

(57) **Abstract**

Method for the connection of electroconductive tracks separated by a laminated insulator, in which we have an initial element (1) made up of a laminate underlayer (2) of dielectric material, coated on both sides by the corresponding electroconductive layers, from which tracks (3a, 3b) have been configured, electrically connected between them by means of electroconductive pins (5) inserted in cross-wise holes (4) punched in predetermined points of said element (1), whereby a separation area is defined (4a) between the holes(4) and the pins(5), and both ends (5a, 5b) of the pins (5) abut from their corresponding tracks (3a, 3b), and its holes are metalized internally prior to the insertion of the pins (5), and subsequently welding of the two ends (5a, 5b) of said pins (5) to their corresponding tracks (3a, 3b) is conducted by applying molten material on only one end (5a) of the pins (5) adjacent to the appropriate tracks (3a).

## Description

### Scope of the invention

The present invention consists in a method for the interconnection of electroconductive tracks, separated by a laminate insulator of dielectric material, apt for the manufacture of printed circuit boards (PCB), in particular, when the thickness of said electroconductive is of 400µm, or thicker, foreseen for power transmission applications. This method allows for the connection of electroconductive tracks configured in the conductive layers of both opposite sides of the board or the PCB, by means of short electroconductive pins, inserted by pressurized means in cross-wise holes in the board created for that purpose, which allow for considerable intensity current flows within the range of its power transmission

The invention also refers to a two-sided printed circuit manufactured according to the method described.

The abovementioned two-sided PCBs with electroconductive layers with a thickness of 400µm, or thicker, are basically used for the electric distribution boxes in motor vehicles. These boxes, such as the one described for example under Patent GB-A-2 263 817 (MAI 92) owned by this applicant, provide a centralized electric connection system for vehicles, acting as a support for protection systems, as well as for many other electric components, such as transmissions, diodes, electronic control modules and connectors. It should be pointed out that all connections between the different components are carried out by means of one or several PCBs, and from the latter it is feasible to distribute/receive power and control signals to/from different parts of the vehicle.

More specifically, this invention refers to an adequate method in order to manufacture two-sided printed circuits, in particular for power transmission applications, whereby the mechanical and electrical connection of said electroconductive pins to the tracks is made in one single welding process, applying molten material on only one end of the pins and the adjacent areas of the appropriate tracks.

### Background of the invention

At present, there are various interconnection techniques for copper tracks located at different levels available for electronic circuits (two-sided, multi-layered, etc.)

One of the techniques used consists in metalizing the inner walls of holes set cross-wise to the PCB by applying an electrolyte metal, such as copper, which provides a conductive layer of just a few microns, and whose holes/bores connect predetermined points of the tracks in the different electroconductive layers.

For many electronic applications, a metalizing thickness usually ranging from 5 to 15µm is usually sufficient for the low current levels generated in signal tracks (usually measured in mA).

On the other hand, the underlayers which are adequate for the metalizing technique are those of the type CEM-1, FR-4, and in general, those whose thermic expansion rate is relatively low.

Regarding the two-sided printed circuits whose tracks have a thickness of 400µm, or more, used in power transmission applications, such as electric distribution boxes, the communication between tracks on each side by metalized holes/bores is hardly feasible, basically due to the following factors:
- the 0.4 mm. thickness of Cu hampers the metalizing process under standard procedures prepared for applications in the field of signal electronics;
- the thickness of the metalized walls would have to be much higher that the standard ones due to the high current traversing these; this implies protracted processing times;
- in general, considering that the manufacture process of the two-sided PCB with electroconductive layer thickness of 400µm, or more, provides very slight differences in respect of the conventional process for less thickness, the introduction of a metalizing process in the holes makes it necessary to readapt this process to take into account such metalization.

Therefore, the process widely used at present for the interconnection of copper tracks of 400µm, or thicker, in two-sided PCBs prepared for power transmission applications is, for example, that described under the abovementioned patent GB-A-22 263 817, and shown specifically in Figure 2 of the drawings, which consists in:
- Insertion of short pins (slightly projecting from both sides of the conductive layers) in the appropriate bores, placed cross-wise to the board, previously made by punching;
- Wave welding of short pins with an alloy such as 63Sn37PB; the welding process is carried out in two stages in order to joint the short pin to one side and then to the other of the printed circuit.
Considering that the welded joint of the abovementioned electroconductive pin to the electroconductive layers or tracks of both sides of the PCB is often subject to temperature changes, usually such variations ranging between -40°C and 85°C, and due to differences in the thermic expansion rates of the different materials used in the joint (weld, copper, underlayer), a thermomechanic stress is appreciated in the welding, and following a considerable number of thermic cycles, such fatigue may entail the appearance of cracks.

On the other hand, it is important to avoid or minimize refusion of the first welding when the second welding is made in order to mitigate the effects of thermomechanic fatigue produced by thermic stress. To that end, more resistant alloys from the mechanic and thermic point of view are being studied in order to avoid the refusion effect: such is the case of the new alloy 96N4Ag. Patent US-A-5.601.227 should also be mentioned, currently held by this applicant, which describes a special alloy with 95% of Sn and 5% of Sb, or 52% of Sn, 45% Pb, and 3% of Sb with a fusion point exceeding 183°C, which make them specially adequate for the welding of printed circuits.

In Patent Application EP-A-0877 529, this Applicant has also proposed a method to obtain an improvement in welding, in particular for the cross-wise components welded to the two conductive sides of a printed circuit, consisting in the use of welding procedures of different characteristics on each of the component ends, so that the two weldings do not interact with each other from a qualitative point of view. To that end, said document describes the use of certain welding alloys with different fusion points for each of the ends of the pins to be welded, in order to avoid refusion of the first welding in the second welding process (which at present is made by using an allow of tin/lead, with a fusion point of 183°C).Wherefore a binary alloy is proposed based on tin and silver which is provided of a greater resistance against thermomechanic fatigue.

### Description of the invention

This invention is based on a radically different principle which avoids welding, which in part makes use of the metalizing technology for PCB holes, applied here -with a usual metalizing thickness of 5 to 15µm or below- to a dielectric underlayer coated with electroconductive layers of 400µm or thicker in its two sides, in combination with the more usual technique in power circuits of using short cross-wise electroconductive connection pins. In this way, the metalized holes of the two-sided PCB are coupled with cross-wise electroconductive pins, with a polygonal section, which are inserted by mechanical pressure and the longitudinal ridges of the pins are in contact with the metalized walls of the holes, leaving certain empty spaces between the sides of the pins and the metalized layer of the hole, and subsequently, a welding process follows applying metal in only one side of the PCB and acting on only one end of each pin, so that the molten metal flows by capillarity between those spaces to the opposite site when the other end of each pin is welded to its corresponding track.

It must be pointed out that under the conventional manufacturing process of printed circuits, as evidenced for example under Patent ES-A-2021545 (MAI90), the insertion in each hole of the PCB of its corresponding cross-wise pin, its length exceeding the thickness of the PCB, and with a quadrangular cross-wise section encompassed by a circle whose diameter is slightly larger that the diameter of those holes was already known, thus, certain separation spaces could be appreciated between the holes and the pins, and such pins become connected by mechanical pressure to those holes, with the ends of the pins slightly abutting from both sides of the element, thus providing an adequate positioning of those pins in order to perform the abovementioned welding operations on each of their tips.

The method herein set out under this invention provides a noticeable improvement on results, if considering the damages and structural stress which the board or the printed circuit may be subject to, thus minimizing the thermodynamic fatigue on the welding carried out initially in one of the sides of the PCB, as such welding is conducted on the other side, all of which will have a favorable impact on the working conditions applicable to this printed circuit, in particular, when used in the electrical distribution boxes of motor vehicles

Obviously, in respect of conventional procedures already mentioned which imply two transitional stages of wave welding, the method herein described allows for their joining in one single stage, which may be seen as an advanpine in processing times.

The coupling of pins and conductive layers are robust and will be formed on both sides by the same material used in the welding process, whereby the effects produced by different thermic expansion rates and interaction between the both weldings is avoided, thus minimizing thermodynamic fatigue.

The method used in this invention includes therefore the following stages:
- an initial metalization stage, technique already known in the art, of the holes/bores intended for the connection of predetermined points of tracks located in opposite sides of the PCB;
- a second stage of fixing and placing the electroconductive pins in contact with the metalized bores, pursuant to a technique already known in the art abovementioned, which provides empty spaces between the pin and its hole, whereby the tip ends of the pins project slightly from both sides of the PCB;
- a last stage of welding in which the material is applied by placing such molten material on only one end of the pins and the adjacent areas of the matching tracks, wherefore the material flows by capillarity through the empty spaces delimited by the conductive wall or the inner metalized layer of the hole and the pin's surface, reaching the opposite end of the pin where the welding of such end is then completed.

It must be pointed out that pursuant to the method herein described, the thickness of inner metalized layer of the holes/bores cross-wise to the PCB may range from 5 to 15µm, that is, the standard measure for metalizing holes/bores which communicate signal circuit tracks, or even lower, as the role of these layers forming a wall, with high conductive properties, within those holes/bores, is merely to facilitate the capillarity flow of the welding material applied, and do not play an essential part in the electrical conduction which is mainly achieved by means of the abovementioned electroconductive pins, placed cross-wise to the PCB, allowing for the intensity flow within the power range.

In general, following the metalization of the inner walls of the cross-wise holes/bores, other holes will be punched in order to assemble the electronic components on the PCB board.

### Brief description of the drawings

The invention will be better understood if a detailed description of preferred embodiments is made, which must be read side by side with the drawings herein attached, where:
Figure 1 is a perspective view of part of the initial element used in the manufacture of a printed circuit board (PCB);
Figure 2, is a perspective view, partially sectioned, of a part of the element shown in Figure 1, after certain openings have been made in the same;
Figure 3 is a cross-wise section of a plane which contains the axis of one of the holes shown in Figure 2, whose inner wall has been metalized;
Figure 4 is a perspective view, part sectioned, which shows the insertion of a pin in the hole of Figure 3;
Figure 5 is a combination of a ground-plant view of part of the element shown in Figure 1, in which one of its holes has been metalized, and the pin shown in Figure 4 has been inserted in the same, and a cross-wise section view from the line marked by a set of arrows in the ground-plant view;
Figure 6 is cross-section view of all the elements of Figure 5 when welding material is being applied to one of its sides; and
Figure 7 is a cross-section global view of Figure 6, once the welding process has been completed, and the two ends of the pins have been welded to the electroconductive tracks of the PCB.

### Detailed description of some examples of preferred embodiments.

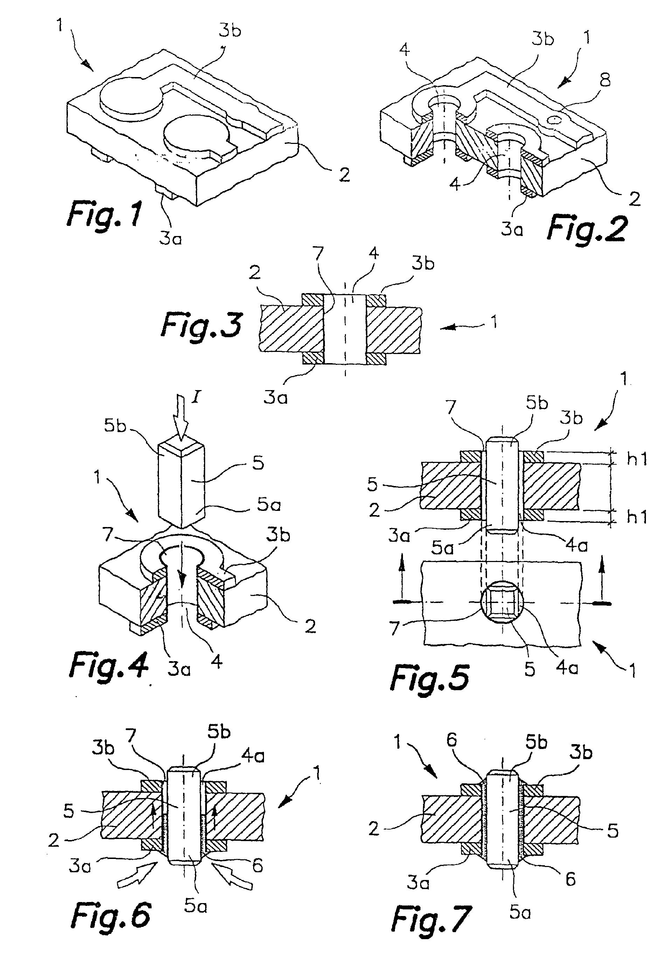

First of all, we shall refer to Figure 1, numbered as 1, which provides a general description of an element within a two-sided printed circuit board, made up of a laminated dielectric underlayer (2), on both sides of which electroconductive tracks 3a, 3b have been configured. The thickness of tracks 3a, 3b is at least approximately 400µm, apt for power transmission circuits.

In many applications an interconnection of predetermined points of both electroconductive layers 3a and 3b of both sides of element (1) is required, by means of underlayer 2 which acts as an insulator. Moreover, in applications for power transmission, as is the main purpose of the method provided by this invention, such connection must be made by a conductive material which provides a cross-section pitch sufficiently large to avoid any undesired electrical resistance to the power supply.

In order to carry out such connections, the first step is to make a certain number of cross-section holes (4) (please refer to Figure 2) in these predetermined points of said element 1, corresponding to those sections of the tracks which are to be connected. Contemporaneously to making these holes (4), certain bores may be made(8) for the assembly of electronic components, although these may be made with the same degree of success after the interconnection of the electroconductive layers 3a, 3b.

In Figure 3, the result of the next step is shown which consists in metalizing by conventional techniques the inner walls of the holes (4). Following the use of this technique a thin metal layer (7) is obtained which coats the inner surface of each hole (4).

Next (Figure 4) the insertion of electroconductive pins(4) in said holes (5) is accomplished, following an insertion pressure I which guarantees a pressure adjustment of the same. Generally, these pins (5) are of a greater length than the thickness of element (1) and of polygonal cross-section, in this case, a square, which may be encompassed in the diameter of a circle slightly larger that the diameter of said holes (4), so that the pins (5) are connected mechanically by pressure to the holes (4), and the ridges of the pins (5) are in contact with the thin metal layer (7) of the inner wall of the hole (4). Thus, (Please refer to Figure 5) between the walls of the holes (4) and the ridges of the pins (5) certain separation areas are noticeable (4a), whereas the tip ends (5a,5b) of the pins (5) slightly abut on both sides of element (1).

Although at this stage, said pins (5) are mechanically fixed to the holes (4), and together with the thin metal layers (7) of the inner walls of the holes (4), provide an electrical connection between the tracks 3a, 3b from side to side of element (1), it becomes necessary to consolidate both the mechanical and electrical connection in order to provide the printed circuit with adequate properties to endure long and adverse working conditions which may include, for example (application of the PCB to the central connection boxes of motorcars), vibration, thermic changes, etc.

In order to achieve such consolidation, welding is required by application of molten (6) material (Please refer to Figure 6), acting exclusively on one end (5a) of each pin (5) and the adjacent area of its matching track 3a, whereby said molten material (6) flows by capillarity between the empty spaces (4). capillarity is encouraged by a predetermined and desirable allowance in the separation spaces (4a), and due to the physical properties of the walls in those separation spaces, delimited by thin metal layers (7) within the holes (4) and the sides of the pins (5).

This capillarity flow continues until the applied material (6) reaches the opposite end of the hole (4) where welding of the other end (5b) of the pin (5) to its corresponding track 3b, takes place. It must be pointed out that the thickness of the thin metal layers (7) only suffices to encourage the capillarity flow of the added material (6), as these thin metal layers (7) are not necessarily involved, nor play an essential part in the electric power transmission.

An expert in the matter shall be capable of introducing different variants in the execution of the method described, without exceeding the scope of this invention, which has been defined by the claims herein attached.

## Claims

1. Method for the connection of electroconductive tracks separated by a laminated insulator, in which we have an initial element (1) made up of a laminate underlayer (2) of dielectric material, coated on both sides by the corresponding electroconductive layers, from which tracks (3a, 3b) have been configured, electrically connected between them by means of electroconductive pins (5) inserted in cross-wise holes (4) punched in predetermined points of said element (1), whereby a separation area is defined (4a) between the holes(4) and the pins(5), and both ends (5a, 5b) of the pins (5) abut from their corresponding tracks (3a, 3b), and are welded to these following the addition of material (6), **characterized in that** those holes (4) are metalized internally prior to the insertion of the pins (5) and welding of the two ends (5a, 5b) of said pins (5) to their corresponding tracks (3a, 3b) is conducted by applying the molten material (6) mentioned above, exclusively on one end (5a) of the pins (5) adjacent to the appropriate tracks (3a).

2. Method, as set forth in Claim 1, **characterized in that** it includes the following subsequent stages:.
(a) perform said cross-wise cylindrical slot holes in predetermined points of element (1), bearing on said underlayer (2) and tracks (3a, 3b);
(b) apply, by means of a metalization technique, a thin metal layer (7) to the inner surface of the holes (4);
(c) insert adjusting with pressure said pins (5) in each hole (4), the pins (5) being of a cross-wise polygonal section encompassed within a circle whose diameter is slightly larger than the diameter of those holes (4), thus providing predetermined empty spaces (4a) of the desired allowance between the thin metal layers (7) of the inside of the holes (4) and the ridges of the pins (5); and
(d) commence the welding process by applying molten material (6) on one of the ends (5a) of each pin (5) and the adjacent area of its corresponding track (3a), so that the molten material (6) flows by capillarity between the empty spaces (4a) to the opposite end, where the second end of the pin (5b) is welded (5) to its corresponding track (3b), whose capillarity is encouraged by the desired allowances in the separation areas (4a) delimited by the thin metal layers (7) of the inside of the holes (4) and the ridges of the pins (5).

3. Method, as set out in Claim 1 or 2, **characterized in that** the thickness of the tracks (3a, 3b) is at least approximately 400µm, apt for power circuits.

4. Method, as set forth in Claim 1 or 2, **characterized in that** the thickness of the thin metal layers (7) is just enough to encourage the capillarity flow of the molten material applied (6), without necessarily playing an essential part in the electric conduction.

5. Method, as set forth in Claim 1 or 2, **characterized in that** in includes punching some holes (8) for the assembly of electronic components subsequently to having made the holes (4) foreseen in step (a).

6. Two-sided printed circuit, **characterized in that** it includes a certain number of tracks configured from electroconductive layers attached to both sides of the dielectric laminate underlayer (2), said tracks being linked according to the method described under Claim 2.

7. Circuit, as set forth in Claim 6, **characterized in that** the thickness of the tracks (3a, 3b) is at least of approximately 400µm, apt for power circuits, and the thickness of the thin metal layers (7) is just enough to encourage the capillarity flow of the molten material applied (6), without necessarily playing an essential part in the electric conduction.
